# EUROPEAN PATENT SPECIFICATION

(11) **EP 4 350 766 B1**
(45) Date of publication and mention of the grant of the patent: **25.06.2025**
(21) Application number: 23198932.8
(22) Date of filing: 21.09.2023
(51) Int. Cl.: H01L 23/538

(54) **EMBEDDED PACKAGE STRUCTURE, POWER SUPPLY APPARATUS, AND ELECTRONIC DEVICE**
EINGEBETTETE GEHÄUSESTRUKTUR, STROMVERSORGUNGSVORRICHTUNG UND ELEKTRONISCHE VORRICHTUNG
STRUCTURE DE BOÎTIER INTÉGRÉ, APPAREIL D'ALIMENTATION ÉLECTRIQUE ET DISPOSITIF ÉLECTRONIQUE

(30) Priority: 08.10.2022 CN 202211223771
(43) Date of publication of application: 10.04.2024
(73) Proprietor: Huawei Digital Power Technologies Co., Ltd., Shenzhen, Guangdong 518043 (CN)
(72) Inventor: ZHAO, Chunyan, Shenzhen, 518043 (CN); SHEN, Chao, Shenzhen, 518043 (CN); BAO, Kuanming, Shenzhen, 518043 (CN)
(74) Representative: Gill Jennings & Every LLP

(56) References cited:
- EP-A1- 3 806 330
- CN-A- 113 451 259
- GB-A- 2 197 540
- US-A1- 2013 223 033
- US-A1- 2019 189 583
- US-A1- 2022 013 444
- US-A1- 2022 367 373

## Description

### TECHNICAL FIELD

The present invention relates to the field of electronic component packaging technologies, and in particular, to an embedded package structure, a power supply apparatus, and an electronic device.

### BACKGROUND

With development of electronic products towards miniaturization, portability, and multifunctionality, an embedded component packaging (Embedded Component Packaging, ECP) technology has become a research hotspot in the field of electronic component packaging technologies. US 2022/013444 A1, EP 3 806 330 A1, and US 2019/189583 A1 discloses embedded component packages. ECP is a package form in which electronic components such as a capacitor, a resistor, and a chip are embedded in a substrate. As ECP can shorten a link path between the components, reduce a transmission loss, improve product integration, reduce outline dimensions of a module, and improve reliability and electro-thermal performance of a product, ECP is an important means of achieving multifunctionality and high performance of a portable electronic device.

The ECP technology can be used in structure design of a power module. Currently, in design of a power module, electronic components are embedded side by side in the substrate. Such design is suitable for a power module with a small or medium power and a small or medium current. With digital development of society, a current of a required power supply module is increasingly large, and a size of an inductor required in the power module is increasingly large. A previous structure design for a power module with small or medium power and small or medium current cannot meet a requirement of a high-current power module for a small occupied area and high heat dissipation.

### SUMMARY

This application provides an embedded package structure, a power supply apparatus, and an electronic device, to reduce an occupied area of ECP and improve a heat dissipation capability.

According to a first aspect, an embodiment of this application provides a power supply apparatus as defined in claim 1.

As a power module requires a larger power supply current, a size of the inductor component that needs to be used in the embedded package structure is also far greater than a size of the capacitor component and a size of the resistor component. Specifically, the thickness of the inductor component may be greater than a thickness of another single electronic component. If the inductor component and another electronic component are tiled in the substrate according to a conventional technology, a large area is occupied, which is not conducive to integration and miniaturization design. Therefore, in the embedded package structure provided in this application, the first electronic components with smaller sizes are stacked, and then arranged in the substrate frame in a two-dimensional manner with the larger-size inductor component. Alternatively, it may be considered that the stacked first electronic components with small sizes are placed in a gap of the larger-size inductor component. This can reduce an area occupied by the entire embedded package structure, and reduce an overall size of the structure, thereby facilitating integration and miniaturization.

In some possible implementations of this application, the embedded package structure may include one or more capacitor components and one or more resistor components, or the embedded package structure may include only a plurality of capacitor components, or the embedded package structure may include only a plurality of resistor components. This is not limited herein.

In some possible implementations of this application, there may be a plurality of component groups in the embedded package structure. One component group includes a group of a plurality of stacked first electronic components. Projections in a horizontal direction of the first electronic components included in the component group overlap with each other. During actual application, a quantity and a position of the component group are not limited. In addition, the plurality of stacked first electronic components in one component group may be of a same type, for example, a plurality of resistor components may be stacked to form one component group. Alternatively, the plurality of stacked first electronic components in one component group may be of different types. For example, refer to the figure. Two capacitor components and two resistor components may be stacked to form one component group.

In some possible implementations of this application, the substrate frame may specifically include a plurality of stacked line layers. In other words, the substrate frame may be formed by stacking the plurality of line layers. A dielectric layer may be disposed between adjacent line layers. Each line layer may have a same thickness as or different thickness from another line layer. This is not limited herein. A circuit trace may be provided on the line layer, and some circuit traces may be connected to the first electronic component. Through the line layer, a quantity of external trace layers of the embedded package structure may be reduced, thereby reducing an overall height of the power module. The plurality of stacked line layers may have first through holes that penetrate all the line layers, and the inductor component may be embedded in the first through holes. The plurality of stacked line layers may further have a second through hole that penetrates one line layer. The plurality of stacked first electronic components may include a first-size electronic component, and the first-size electronic component is embedded in the second through hole. The first-size electronic component refers to a first electronic component whose thickness roughly matches a thickness of a line layer in which the first-size electronic component is to be embedded, so that the first-size electronic component can be embedded in the second through hole in the single line layer. The first-size electronic component may be specifically a resistor component or a capacitor component. This is not limited herein. A quantity of line layers included in the substrate frame is determined by the thickness of the inductor component. In other words, a total thickness of the stacked line layers is generally approximately equal to the thickness of the inductor component. A total thickness of a plurality of stacked first electronic components in one component group may also be approximately equal to the thickness of the inductor component. For example, when the substrate frame includes four stacked line layers, the first through hole for embedding the inductor component penetrates the four line layers, two second through holes are disposed in each line layer, and a capacitor component or a resistor component is embedded in each through hole.

In some possible implementations of this application, the plurality of stacked lines may further have a third through hole that penetrates at least two adjacent line layers. The plurality of stacked first electronic components may further include a second-size electronic component, the second-size electronic component may be embedded in the third through hole, and a thickness of the second-size electronic component is greater than a thickness of the first-size electronic component. According to an actual design requirement, in the embedded package structure, the first electronic components may have different sizes. For example, capacitor components of different sizes and resistor components of different sizes may exist. A first electronic component of a larger size may be the second-size electronic component. A second through hole using a single line layer cannot be embedded with the second-size electronic component. Therefore, a third through hole that penetrates a plurality of line layers may be provided. For example, refer to the figure. A third through hole that penetrates two line layers may be provided, and a capacitor component and a resistor component of relatively large sizes may be embedded in the third through hole. In this way, in the embedded package structure, depending on different sizes of the disposed first electronic components, there may be a component group including three stacked first electronic components, or there may be a component group including four stacked first electronic components. A larger thickness of the first electronic component indicates a larger quantity of line layers penetrated by the third through hole for embedding a component, and a smaller quantity of first electronic components included in the component group.

In some possible implementations of this application, in the embedded package structure, there may also be a first electronic component, for example, a large-sized capacitor component, whose thickness is close to the thickness of the inductor component. The capacitor component is directly embedded in the substrate frame and is not stacked with another first electronic component.

In some possible implementations of this application, to maximally integrate the electronic components, a second through hole or a third through hole may be disposed at a same position in a vertical direction on the line layers, so that a maximal quantity of first electronic components are stacked in the component group. Alternatively, in some other possible implementations of this application, the second through hole or the third through hole may not be disposed at a specific position of a line layer, that is, no first electronic component is embedded in a line layer in the component group. Some signal interference may be shielded through the line layer. For example, the second through hole is not disposed in a second line layer in the component group on the left in the figure.

In some possible implementations of this application, the embedded package structure may further include a first interconnect line layer located on the substrate frame, and a second interconnect line layer located on a side that is of the substrate frame and that is away from the first interconnect line layer. During specific implementation, the first interconnect line layer and the second interconnect line layer each may include at least one conductive layer, and a circuit trace is provided on the conductive layer. When the first interconnect line layer and the second interconnect line layer each include two or more conductive layers, an insulation dielectric layer is further provided between adjacent conductive layers. A medium via is provided in the insulation dielectric layer to connect circuit traces on the different conductive layers. It should be noted that, a quantity of conductive layers included in each of the first interconnect line layer and the second interconnect line layer is not limited in this application, and may be designed based on an actual requirement.

In some possible implementations of this application, blind vias that penetrate all the line layers may be provided in the substrate frame. Conduction of the first interconnect line layer and the second interconnect line layer may be implemented through the blind vias.

In the embodiment of this application, through the first interconnect line layer and the second interconnect line layer, the inductor component and the first electronic components embedded in the substrate frame may be led out and connected to components located outside the embedded package structure.

Specifically, one end of a winding of the inductor component embedded in the substrate frame may be electrically connected to the first interconnect line layer, and the other end of the winding of the inductor component may be electrically connected to the second interconnect line layer. The winding of the inductor component is directly conducted with the first interconnect line layer and the second interconnect line layer, so that a current flowing through the inductor component can directly flow from top to bottom through the winding, and a current path is perpendicular to the substrate frame. This greatly shortens the current path.

Specifically, in the plurality of stacked first electronic components, a first electronic component stacked on a top layer may be directly electrically connected to the first interconnect line layer, a first electronic component stacked on a bottom layer may be directly electrically connected to the second interconnect line layer, and a first electronic component stacked on a middle layer may be electrically connected to the first interconnect line layer or the second interconnect line layer through a vertical interconnect component. The vertical interconnect component may be a copper column, or may be another connecting component, which is not limited herein. For example, a middle capacitor component may be electrically connected to the first interconnect line layer through a vertical interconnect component, and a middle resistor component may be electrically connected to the second interconnect line layer through a vertical interconnect component, or vice versa.

In some possible implementations of this application, in the plurality of stacked first electronic components, all the first electronic components may be electrically connected to the first interconnect line layer through different vertical interconnect components, or all the first electronic components may be electrically connected to the second interconnect line layer through different vertical interconnect components.

The power supply apparatus provided in this application includes an embedded package structure and at least one second electronic component located on the embedded package structure, where the at least one second electronic component includes at least one chip. In the power supply apparatus provided in this embodiment of this application, an inductor component, a capacitor component, and a resistor component are embedded in the embedded package structure. Then, the chip is disposed on the embedded package structure, so that the chip serving as a main heat source is placed on a surface of the power supply apparatus. Compared with an existing power module structure in which a chip is embedded in a substrate to form an ECP module and an inductor is mounted on a surface of the ECP module, in the embedded package structure provided in this application, a main heat dissipation path of the chip is changed from an existing downward heat dissipation direction to an upward heat dissipation direction, which may improve a heat dissipation capability.

In some possible implementations of this application, the at least one second electronic component may further include at least one capacitor component and/or at least one resistor component. The chip, the capacitor component, and the resistor component that are used as the second electronic components may alternatively be tiled on a surface of the embedded package structure, rather than be stacked.

In this application, the second electronic component may be connected to the embedded package structure in a plurality of manners.

In some possible implementations of this application, the at least one second electronic component may be packaged on the embedded package structure. For example, the chip may be directly flip-packaged (FC) on the first interconnect line layer of the embedded package structure. In addition, when there are a plurality of second electronic components, the second electronic components may be uniformly plastic-packaged. For example, the chip, the capacitor component, and the resistor component may be uniformly plastic-packaged.

In some possible implementations of this application, when there are a plurality of second electronic components, the second electronic component may alternatively be independently plastic-packaged, for example, the chip is independently plastic-packaged.

The at least one second electronic component is first packaged on a first circuit board, and then the first circuit board is electrically connected to the embedded package structure.

In some possible implementations of this application, the at least one second electronic component may be embedded in a second circuit board to form another embedded package structure, and then the second circuit board is electrically connected to the embedded package structure, that is, two ECP structures are interconnected.

In some possible implementations of this application, a heat dissipation module may be further disposed on a surface that is of the at least one chip and that is away from the embedded package structure, namely, a rear side of the chip. The rear side of the chip is connected to the heat dissipation module. Because an area of the chip occupies only 30% to 40% of an area of a voltage apparatus, if heat is dissipated only through an exposed part on the rear side of the chip, a heat dissipation capability is limited. Therefore, the heat dissipation module is disposed to expand a heat dissipation area and improve the heat dissipation capability.

Specifically, the heat dissipation module may be a metal layer covering a packaging surface of the at least one second electronic component. An area of the metal layer is far greater than a surface area of the rear side of the chip. Therefore, a heat dissipation area is expanded, and the heat dissipation capability is improved.

Alternatively, specifically, the heat dissipation module may include a metal layer covering a surface (that is, the rear side of the chip) that is of the at least one chip and that is away from the embedded package structure, and a heat sink connected to the metal layer. As metal has a strong heat transfer capability, heat of the chip can be transferred to the heat sink through the metal layer for heat dissipation.

According to a third aspect, an embodiment of this application further provides an electronic device, including a third circuit board and a power supply apparatus disposed on the third circuit board. The power supply apparatus is the power supply apparatus provided in any embodiment of the second aspect of this application. Because the power supply apparatus has the technical effect of the second aspect, the electronic device including the power supply apparatus also has better heat dissipation performance, and can significantly improve reliability and an electrical characteristic of an ECP product.

For technical effects that can be achieved in the second aspect and the third aspect, refer to the descriptions of technical effects that can be achieved in any possible design of the first aspect. Details are not described herein again.

### BRIEF DESCRIPTION OF DRAWINGS

FIG. 1a is a schematic diagram of a structure of a power module in a conventional technology;
FIG. 1b is a schematic diagram of a structure of another power module in a conventional technology;
FIG. 2 is a schematic diagram of an embedded package structure according to an embodiment of this application;
FIG. 3 is a schematic diagram of another embedded package structure according to an embodiment of this application;
FIG. 4 is a schematic diagram of still another embedded package structure according to an embodiment of this application;
FIG. 5 is a schematic diagram of yet another embedded package structure according to an embodiment of this application;
FIG. 6 is a schematic diagram of still yet another embedded package structure according to an embodiment of this application;
FIG. 7 is a schematic diagram of a structure of a power supply apparatus according to an embodiment of this application;
FIG. 8 is a schematic diagram of a structure of another power supply apparatus according to an embodiment of this application;
FIG. 9 is a schematic diagram of a structure of still another power supply apparatus according to an embodiment of this application;
FIG. 10 is a schematic diagram of a structure of yet another power supply apparatus according to an embodiment of this application;
FIG. 11 is a schematic diagram of a structure of still yet another power supply apparatus according to an embodiment of this application;
FIG. 12 is a schematic diagram of a structure of a further power supply apparatus according to an embodiment of this application;
FIG. 13 is a schematic diagram of a structure of a still further power supply apparatus according to an embodiment of this application;
FIG. 14 is a schematic diagram of a structure of a yet further power supply apparatus according to an embodiment of this application; and
FIG. 15 is a schematic diagram of a structure of an electronic device according to an embodiment of this application.

### DESCRIPTION OF EMBODIMENTS

To make the objectives, technical solutions, and advantages of this application clearer, the following further describes this application in detail with reference to the accompanying drawings. However, example embodiments may be implemented in a plurality of forms and should not be construed as being limited to embodiments described herein. On the contrary, these embodiments are provided such that this application is more comprehensive and complete and fully conveys the concept of the example embodiments to persons skilled in the art. Identical reference numerals in the accompanying drawings denote identical or similar structures. Therefore, repeated description thereof is omitted. Expressions of positions and directions in this application are described by using the accompanying drawings as an example. However, changes may also be made as required, and all the changes fall within the protection scope of this application. The accompanying drawings in this application are merely used to illustrate relative position relationships and do not represent an actual scale.

It should be noted that specific details are set forth in the following description to provide a thorough understanding of this application. However, this application can be implemented in numerous other manners different from those described herein, and persons skilled in the art can make similar inferences without departing from the connotation of this application. Therefore, this application is not limited to the specific implementations disclosed below. Example implementations of this application are subsequently described in the specification, but the description is intended to describe general principles of this application and is not intended to limit the scope of this application. The protection scope of this application is subject to the appended claims.

To facilitate understanding of embodiments of this application, the following first describes related technologies used in the embodiments of this application.

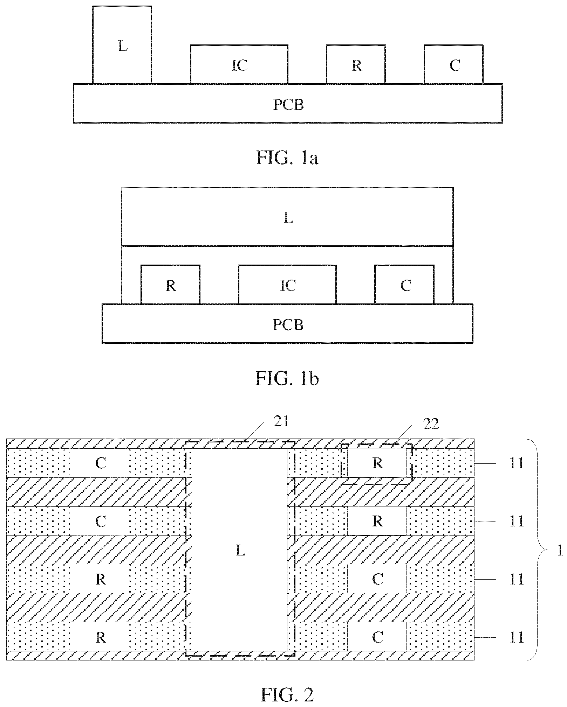

Refer to FIG. 1a. In an existing design solution of a power module, electronic components such as a chip (IC), a capacitor (C), a resistor (R), and an inductor (L) are tiled on a printed circuit board (print circuit board, PCB) for power supply and control. This type of power module occupies a quite large area of the PCB board, which is not conducive to miniaturization and integration.

Refer to FIG. 1b. In another existing design solution of a power module, a chip (IC), a capacitor (C), and a resistor (R) are embedded in a substrate to form an ECP module, and then an inductor (L) is mounted on a surface of the ECP module to construct a power module of a three-dimensional stacked structure. Such power module in which the inductor (L) is disposed in a stacked manner can reduce an occupied area to some extent, and high integration of the components can reduce a parasitic parameter. However, as a main heat source of the power module, the chip (IC) is integrated inside the ECP module, and wrapped by a dielectric layer. This causes a poor heat dissipation capability of the power module. In addition, a heat dissipation channel of the chip (IC) needs to pass through the substrate of the ECP, which also has limitation.

In view of this, an embodiment of this application provides an embedded package structure, which may be applied to a power module but is not limited to being applied to the power module.

FIG. 2 is a schematic diagram of an example of an embedded package structure according to an embodiment of this application.

Refer to FIG. 2. The embedded package structure provided in this embodiment of this application may specifically include: a substrate frame 1, an inductor component L embedded in the substrate frame 1, and a plurality of stacked first electronic components that are embedded in the substrate frame 1. The inductor component L and the plurality of stacked first electronic components may be embedded in different positions of the substrate frame 1. It may be considered that the inductor component L and the plurality of stacked first electronic components are tiled or arranged in a two-dimensional manner. A thickness of the inductor component L is generally greater than a thickness of any one of the plurality of first electronic components. The first electronic component is a passive electronic component. Any one of the plurality of first electronic components may be specifically a capacitor component C or a resistor component R.

As a power module requires a larger power supply current, a size of the inductor component L that needs to be used in the embedded package structure is also far greater than a size of the capacitor component C and a size of the resistor component R. Specifically, the thickness of the inductor component L may be greater than a thickness of another single electronic component. If the inductor component L and another electronic component are tiled in the substrate according to a conventional technology, a large area is occupied, which is not conducive to integration and miniaturization design. Therefore, in the embedded package structure provided in this application, the first electronic components with smaller sizes are stacked, and then arranged in the substrate frame 1 in a two-dimensional manner with the inductor component L with a larger size. Alternatively, it may be considered that the stacked first electronic components with small sizes are placed in a gap of the inductor component L with a larger size. This can reduce an area occupied by the entire embedded package structure, and reduce an overall size of the structure, thereby facilitating integration and miniaturization.

In this embodiment of this application, the embedded package structure may include one or more capacitor components C and one or more resistor components R, or the embedded package structure may include only a plurality of capacitor components C, or the embedded package structure may include only a plurality of resistor components R. This is not limited herein.

In this embodiment of this application, there may be a plurality of component groups in the embedded package structure. One component group includes a group of a plurality of stacked first electronic components. Projections in a horizontal direction of the first electronic components included in the component group overlap with each other. FIG. 2 shows two component groups respectively located on two sides of the inductor component L. During actual application, a quantity and a position of the component group are not limited. In addition, the plurality of stacked first electronic components in one component group may be of a same type, for example, a plurality of resistor components R may be stacked to form one component group. Alternatively, the plurality of stacked first electronic components in one component group may be of different types. For example, refer to FIG. 2. Two capacitor components C and two resistor components R may be stacked to form one component group.

Refer to FIG. 2. In some embodiments of this application, the substrate frame 1 may specifically include a plurality of stacked line layers 11. In other words, the substrate frame 1 may be formed by stacking the plurality of line layers 11. A dielectric layer may be disposed between adjacent line layers 11. Each line layer 11 may have a same thickness as or different thickness from another line layer. This is not limited herein. A circuit trace may be provided on the line layer 11, and some circuit traces may be connected to the first electronic component. Through the line layer 11, a quantity of external trace layers of the embedded package structure may be reduced, thereby reducing an overall height of the power module. The plurality of stacked line layers 11 may have first through holes 21 that penetrate all the line layers 11, and the inductor component L may be embedded in the first through holes 21. The plurality of stacked line layers 11 may further have a second through hole 22 that penetrates one line layer 11. The plurality of stacked first electronic components may include a first-size electronic component, and the first-size electronic component is embedded in the second through hole 22. The first-size electronic component refers to a first electronic component whose thickness roughly matches a thickness of a line layer 11 in which the first-size electronic component is to be embedded, so that the first-size electronic component can be embedded in the second through hole 22 in the single line layer. The first-size electronic component may be specifically a resistor component R or a capacitor component C. This is not limited herein. A quantity of line layers 11 included in the substrate frame 1 is determined by the thickness of the inductor component L. In other words, a total thickness of the stacked line layers 11 is generally approximately equal to the thickness of the inductor component L. A total thickness of a third through hole in which a plurality of first electronic components are stacked in one component group may also be approximately equal to the thickness of the inductor component L. FIG. 2 shows a case in which the substrate frame 1 includes four stacked line layers 11, where the first through hole 21 for embedding the inductor component L penetrates the four line layers 11, two second through holes 22 are disposed in each line layer 11, and a capacitor component C or a resistor component R is embedded in each through hole 22.

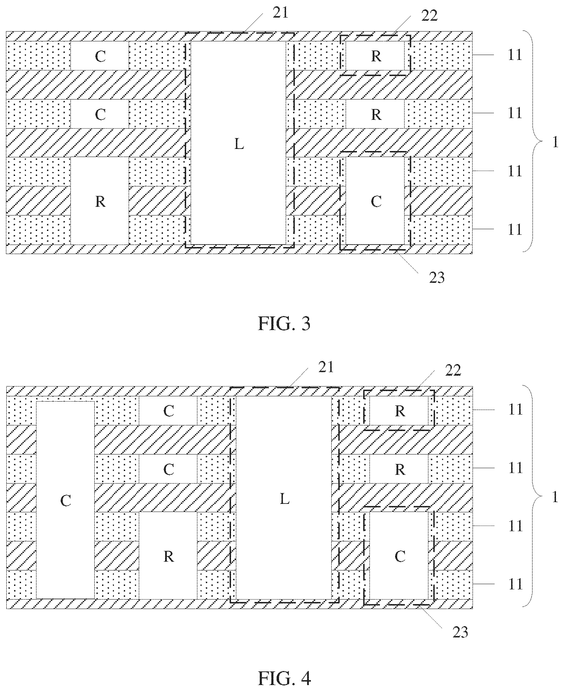

FIG. 3 is a schematic diagram of an example of another embedded package structure according to an embodiment of this application.

Refer to FIG. 3. In some other embodiments of this application, the plurality of stacked lines 11 may further have a third through hole 23 that penetrates at least two adjacent line layers 11. The plurality of stacked first electronic components may further include a second-size electronic component, the second-size electronic component may be embedded in the third through hole 23, and a thickness of the second-size electronic component is greater than a thickness of the first-size electronic component. According to an actual design requirement, in the embedded package structure, the first electronic components may have different sizes. For example, capacitor components C of different sizes and resistor components R of different sizes may exist. A first electronic component of a larger size may be the second-size electronic component. A second through hole 22 using a single line layer cannot be embedded with the second-size electronic component. Therefore, a third through hole 23 that penetrates a plurality of line layers 11 may be provided. For example, refer to FIG. 3. A third through hole 23 that penetrates two line layers 11 may be provided, and a capacitor component C and a resistor component R of relatively large sizes may be embedded in the third through hole 23. In this way, in the embedded package structure, depending on different sizes of the disposed first electronic components, there may be a component group including three stacked first electronic components, or there may be a component group including four stacked first electronic components. A larger thickness of the first electronic component indicates a larger quantity of line layers 11 penetrated by the third through hole 23 for embedding a component, and a smaller quantity of first electronic components included in the component group.

FIG. 4 is a schematic diagram of an example of still another embedded package structure according to an embodiment of this application.

Refer to FIG. 4. In some other embodiments of this application, in the embedded package structure, there may also be a first electronic component, for example, a large-sized capacitor component C, whose thickness is close to the thickness of the inductor component L. The capacitor component C is directly embedded in the substrate frame 1 and is not stacked with another first electronic component.

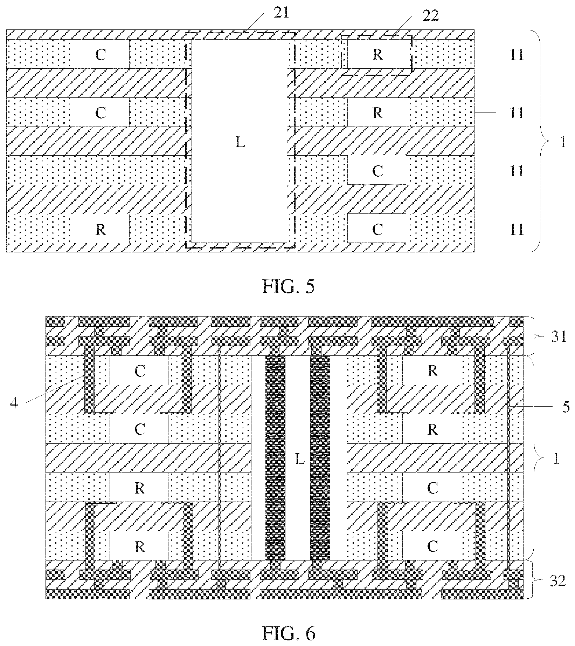

FIG. 5 is a schematic diagram of an example of yet another embedded package structure according to an embodiment of this application.

Refer to FIG. 2 to FIG. 4. In some embodiments of this application, to maximally integrate electronic components, a second through hole 22 or a third through hole 23 may be disposed at a same position in a vertical direction on the line layers 11, so that a maximal quantity of first electronic components are stacked in the component group. Alternatively, refer to FIG. 5. In some other embodiments of this application, the second through hole 22 or the third through hole 23 may not be disposed at a specific position of a line layer 11, that is, no first electronic component is embedded in a line layer 11 in the component group. Some signal interference may be shielded through the line layer 11. For example, the second through hole 22 is not disposed in a second line layer 11 in the component group on the left in FIG. 5.

FIG. 6 is a schematic diagram of an example of still yet another embedded package structure according to an embodiment of this application.

Refer to FIG. 6. In some embodiments of this application, the embedded package structure may further include a first interconnect line layer 31 located on the substrate frame 1, and a second interconnect line layer 32 located on a side that is of the substrate frame 1 and that is away from the first interconnect line layer 31. During specific implementation, the first interconnect line layer 31 and the second interconnect line layer 32 each may include at least one conductive layer, and a circuit trace is provided on the conductive layer. When the first interconnect line layer 31 and the second interconnect line layer 32 each include two or more conductive layers, an insulation dielectric layer is further provided between adjacent conductive layers. A medium via is provided in the insulation dielectric layer to connect circuit traces on the different conductive layers. It should be noted that, a quantity of conductive layers included in each of the first interconnect line layer 31 and the second interconnect line layer 32 is not limited in this application, and may be designed based on an actual requirement. FIG. 6 is described by merely using an example in which the first interconnect line layer 31 and the second interconnect line layer 32 each include two conductive layers.

Refer to FIG. 6. In some embodiments of this application, blind vias 5 that penetrate all the line layers 11 may be provided in the substrate frame 1. Conduction of the first interconnect line layer 31 and the second interconnect line layer 32 may be implemented through the blind vias 5.

In this embodiment of this application, through the first interconnect line layer 31 and the second interconnect line layer 32, the inductor component L and the first electronic components embedded in the substrate frame 1 may be led out and connected to components located outside the embedded package structure.

Specifically, one end of a winding of the inductor component L embedded in the substrate frame 1 may be electrically connected to the first interconnect line layer 31, and the other end of the winding of the inductor component L may be electrically connected to the second interconnect line layer 32. FIG. 6 shows a case in which two vertical windings are disposed in the inductor component L. The winding of the inductor component L is directly conducted with the first interconnect line layer 31 and the second interconnect line layer 32, so that a current flowing through the inductor component L can directly flow from top to bottom through the winding, and a current path is perpendicular to the substrate frame 1. This greatly shortens the current path.

Specifically, in the plurality of stacked first electronic components, a first electronic component stacked on a top layer may be directly electrically connected to the first interconnect line layer 31, a first electronic component stacked on a bottom layer may be directly electrically connected to the second interconnect line layer 32, and a first electronic component stacked on a middle layer may be electrically connected to the first interconnect line layer 31 or the second interconnect line layer 32 through a vertical interconnect component 4. The vertical interconnect component may be a copper column, or may be another connecting component, which is not limited herein. For example, in a component group on the left of FIG. 6, a middle capacitor component C may be electrically connected to the first interconnect line layer 31 through a vertical interconnect component 4, and a middle resistor component R may be electrically connected to the second interconnect line layer 32 through a vertical interconnect component 4, or vice versa.

In some other embodiments of this application, in the plurality of stacked first electronic components, all the first electronic components may be electrically connected to the first interconnect line layer 31 through different vertical interconnect components, or all the first electronic components may be electrically connected to the second interconnect line layer 32 through different vertical interconnect components.

The embedded package structure provided in this application may be applied to a power module. Based on this, an embodiment of this application further provides a power supply apparatus, and the power supply apparatus may include the embedded package structure provided in the foregoing embodiment of this application.

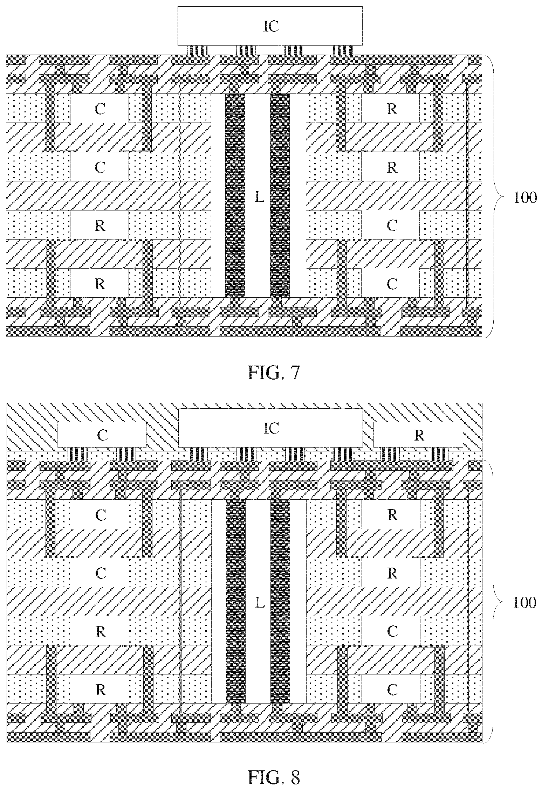

FIG. 7 is a schematic diagram of an example structure of a power supply apparatus according to an embodiment of this application.

Refer to FIG. 7. The power supply apparatus provided in this embodiment of this application may specifically include an embedded package structure 100 and at least one second electronic component located on the embedded package structure 100. The at least one second electronic component may include at least one chip IC. In the power supply apparatus provided in this embodiment of this application, an inductor component, a capacitor component, and a resistor component are embedded in the embedded package structure 100. Then, the chip IC is disposed on the embedded package structure 100, so that the chip IC serving as a main heat source is placed on a surface of the power supply apparatus. Compared with an existing power module structure in which a chip IC is embedded in a substrate to form an ECP module and an inductor (L) is mounted on a surface of the ECP module, in the embedded package structure provided in this application, a main heat dissipation path of the chip IC is changed from an existing downward heat dissipation direction to an upward heat dissipation direction, which may improve a heat dissipation capability.

FIG. 8 is a schematic diagram of an example structure of another power supply apparatus according to an embodiment of this application.

Refer to FIG. 8. In some embodiments of this application, the at least one second electronic component may further include at least one capacitor component C and/or at least one resistor component R. The chip IC, the capacitor component C, and the resistor component R that are used as the second electronic components may alternatively be tiled on a surface of the embedded package structure, rather than be stacked.

In this application, the second electronic component may be connected to the embedded package structure 100 in a plurality of manners.

Refer to FIG. 8. In some embodiments of this application, the at least one second electronic component may be packaged on the embedded package structure 100. For example, the chip IC may be directly flip-packaged (FC) on the first interconnect line layer 31 of the embedded package structure 100. Refer to FIG. 8. When there are a plurality of second electronic components, the second electronic components may be uniformly plastic-packaged. For example, the chip IC, the capacitor component C, and the resistor component R in FIG. 8 may be uniformly plastic-packaged.

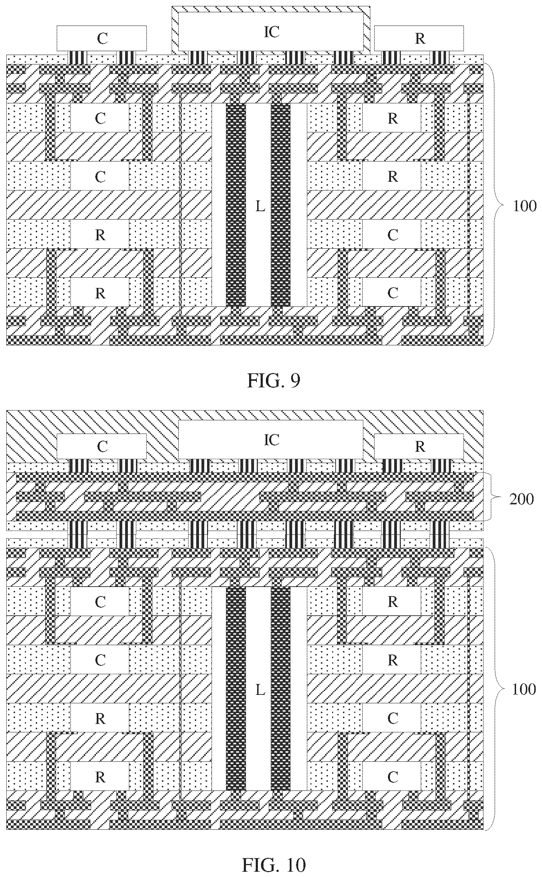

FIG. 9 is a schematic diagram of an example structure of still another power supply apparatus according to an embodiment of this application.

Refer to FIG. 9. In some other embodiments of this application, when there are a plurality of second electronic components, the second electronic components may alternatively be independently plastic-packaged, for example, the chip IC in FIG. 9 is independently plastic-packaged.

FIG. 10 is a schematic diagram of an example structure of yet another power supply apparatus according to an embodiment of this application.

Refer to FIG. 10. In embodiments of this application, the at least one second electronic component is packaged on a first circuit board 200, and the first circuit board 200 is electrically connected to the embedded package structure 100.

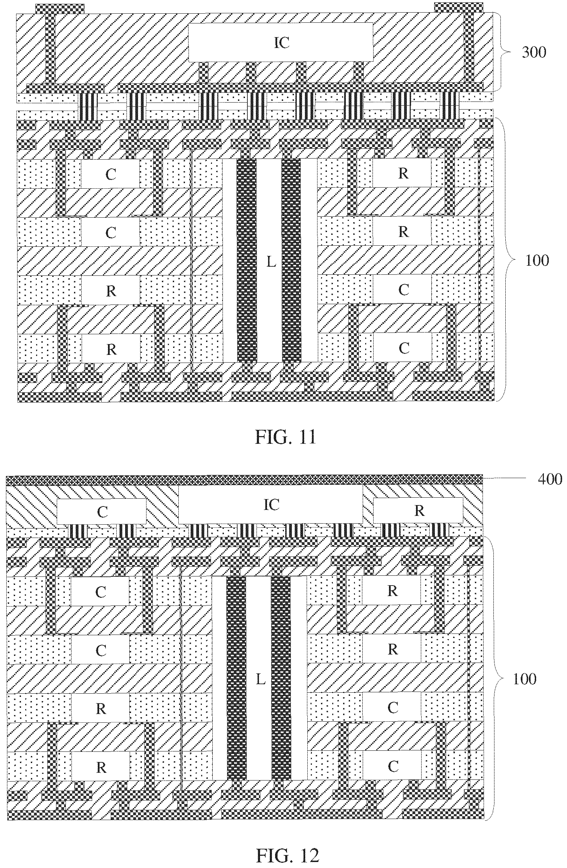

FIG. 11 is a schematic diagram of an example structure of still yet another power supply apparatus according to an embodiment of this application.

Refer to FIG. 11. In some other embodiments of this application, the at least one second electronic component may be embedded in a second circuit board 300 to form another embedded package structure, and then the second circuit board 300 is electrically connected to the embedded package structure 100, that is, two ECP structures are interconnected.

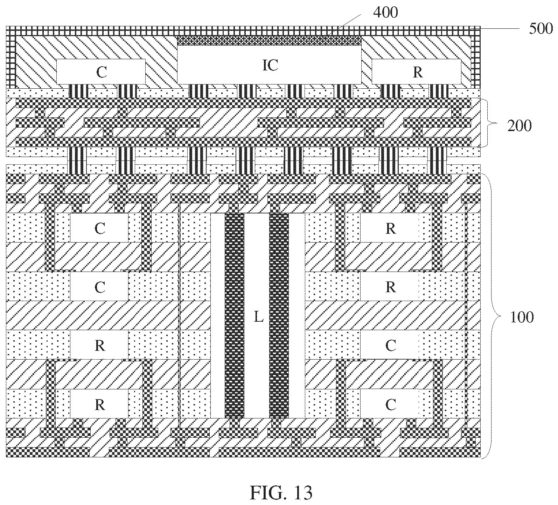

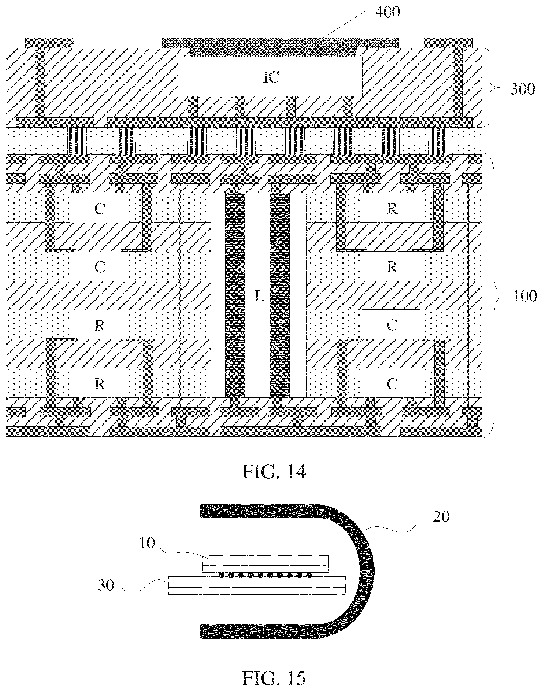

FIG. 12 is a schematic diagram of an example structure of a further power supply apparatus according to an embodiment of this application. FIG. 13 is a schematic diagram of an example structure of a still further power supply apparatus according to an embodiment of this application. FIG. 14 is a schematic diagram of an example structure of a yet further power supply apparatus according to an embodiment of this application.

Refer to FIG. 12 to FIG. 14. In some embodiments of this application, a heat dissipation module may be further disposed on a surface that is of the at least one chip IC and that is away from the embedded package structure 100, namely, a rear side of the chip IC. The rear side of the chip IC is connected to the heat dissipation module. Because an area of the chip IC occupies only 30% to 40% of an area of a voltage apparatus, if heat is dissipated only through an exposed part on the rear side of the chip IC, a heat dissipation capability is limited. Therefore, the heat dissipation module is disposed to expand a heat dissipation area and improve the heat dissipation capability.

Specifically, refer to FIG. 12 and FIG. 13. The heat dissipation module may be a metal layer 400 covering a packaging surface of the at least one second electronic component. An area of the metal layer 400 is far greater than a surface area of the rear side of the chip IC. Therefore, a heat dissipation area is expanded, and the heat dissipation capability is improved.

Specifically, refer to FIG. 14. The heat dissipation module may include a metal layer 400 covering a surface (that is, the rear side of the chip IC) that is of the at least one chip IC and that is away from the embedded package structure 100, and a heat sink 500 connected to the metal layer 400. As metal has a strong heat transfer capability, heat of the chip IC may be transferred to the heat sink 500 through the metal layer 400 for heat dissipation.

The power supply apparatus provided in embodiments of this application may be applied to various electronic devices, such as a smartphone, a smart television, a smart television set top box, a personal computer (personal computer, PC), a wearable device, and a smart broadband. It should be noted that the power supply apparatus provided in embodiments of this application is intended to include but is not limited to being applied to these electronic devices and any electronic device of another proper type. Refer to FIG. 15. A mobile phone is used as an example. The electronic device includes a housing 20 and a third circuit board disposed in the housing 20, where a power supply apparatus 10 is disposed on the third circuit board. The third circuit board may be a mainboard 30 of the electronic device, and the power supply apparatus 10 is electrically connected to the mainboard 30.

## Claims

1. A power supply apparatus comprising an embedded package structure (100), comprising: a substrate frame (1), an inductor component (L) embedded in the substrate frame, and a plurality of stacked first electronic components that are embedded in the substrate frame, wherein
the inductor component and the plurality of stacked first electronic components are embedded in different positions of the substrate frame;
a thickness of the inductor component is greater than a thickness of any one of the plurality of first electronic components; and
any one of the plurality of first electronic components is a capacitor component (C) or a resistor component (R);
**characterized in that** the power supply apparatus further comprises at least one second electronic component located on the embedded package structure, wherein the at least one second electronic component comprises at least one chip (IC), wherein the at least one second electronic component is packaged on a first circuit board (200), and the first circuit board is electrically connected to the embedded package structure.

2. The power supply apparatus according to claim 1, wherein the substrate frame has a plurality of stacked line layers (11);
the plurality of stacked line layers have first through holes (22) that penetrate all the line layers, and the inductor component is embedded in the first through holes; and
the plurality of stacked line layers further have a second through hole (22) that penetrates one line layer, the plurality of stacked first electronic components comprise a first-size electronic component, and the first-size electronic component is embedded in the second through hole.

3. The power supply apparatus according to claim 2, wherein the plurality of stacked line layers further have a third through hole (23) that penetrates at least two adjacent line layers; and
the plurality of stacked first electronic components further comprises a second-size electronic component, the second-size electronic component is embedded in the third through hole, and a thickness of the second-size electronic component is greater than a thickness of the first-size electronic component.

4. The power supply apparatus according to any one of claims 1 to 3, further comprising a first interconnect line layer (31) and a second interconnect line layer (32), wherein
the first interconnect line layer is located on the substrate frame, and the second interconnect line layer is located on a side that is of the substrate frame and that is away from the first interconnect line layer; and
one end of a winding of the inductor component is electrically connected to the first interconnect line layer, and the other end of the winding of the inductor component is electrically connected to the second interconnect line layer.

5. The power supply apparatus according to claim 4, wherein in the plurality of stacked first electronic components, a first electronic component stacked on a top layer is electrically connected to the first interconnect line layer, a first electronic component stacked on a bottom layer is electrically connected to the second interconnect line layer, and a first electronic component stacked on a middle layer is electrically connected to the first interconnect line layer or the second interconnect line layer through a vertical interconnect component (4).

6. The power supply apparatus according to any preceding claim, wherein the at least one second electronic component is packaged on the embedded package structure.

7. The power supply apparatus according to any preceding claim, wherein the at least one second electronic component is embedded in a second circuit board (300), and the second circuit board is electrically connected to the embedded package structure.

8. The power supply apparatus according to any preceding claim, wherein the at least one second electronic component further comprises at least one capacitor component and/or at least one resistor component.

9. The power supply apparatus according to any preceding claim, further comprising a heat dissipation module, wherein a surface that is of the at least one chip and that is away from the embedded package structure is connected to the heat dissipation module.

10. The power supply apparatus according to claim 9, wherein the heat dissipation module is a metal layer (400) covering a packaging surface of the at least one second electronic component; or
the heat dissipation module comprises a metal layer (400) covering the surface that is of the at least one chip and that is away from the embedded package structure, and a heat sink connected to the metal layer.

11. An electronic device, comprising: a third circuit board and the power supply apparatus according to claim 7 that is disposed on the third circuit board.

## Patentansprüche

1. Stromversorgungseinrichtung, umfassend eine eingebettete Paketstruktur (100), umfassend: einen Substratrahmen (1), eine in dem Substratrahmen eingebettete Induktorkomponente (L) und eine Vielzahl von gestapelten ersten elektronischen Komponenten, die in dem Substratrahmen eingebettet sind, wobei
die Induktorkomponente und die Vielzahl von gestapelten ersten elektronischen Komponenten in verschiedenen Positionen des Substratrahmens eingebettet sind;
eine Dicke der Induktorkomponente größer als eine Dicke einer beliebigen der Vielzahl von ersten elektronischen Komponenten ist; und
eine beliebige der Vielzahl von ersten elektronischen Komponenten eine Kondensatorkomponente (C) oder eine Widerstandskomponente (R) ist;
**dadurch gekennzeichnet, dass** die Stromversorgungseinrichtung ferner mindestens eine zweite elektronische Komponente umfasst, die sich auf der eingebetteten Paketstruktur befindet, wobei die mindestens eine zweite elektronische Komponente mindestens einen Chip (IC) umfasst, wobei die mindestens eine zweite elektronische Komponente auf einer ersten Leiterplatte (200) verpackt ist und die erste Leiterplatte elektrisch mit der eingebetteten Paketstruktur verbunden ist.

2. Stromversorgungseinrichtung nach Anspruch 1, wobei der Substratrahmen eine Vielzahl von gestapelten Leitungsschichten (11) aufweist;
die Vielzahl der gestapelten Leitungsschichten erste Durchgangslöcher (22) aufweist, die alle Leitungsschichten durchdringen, und die Induktorkomponente in den ersten Durchgangslöchern eingebettet ist; und
die Vielzahl von gestapelten Leitungsschichten ferner ein zweites Durchgangsloch (22) aufweist, das eine Leitungsschicht durchdringt, die Vielzahl von gestapelten ersten elektronischen Komponenten eine elektronische Komponente erster Größe umfasst und die elektronische Komponente erster Größe in dem zweiten Durchgangsloch eingebettet ist.

3. Stromversorgungseinrichtung nach Anspruch 2, wobei die Vielzahl von gestapelten Leitungsschichten ferner ein drittes Durchgangsloch (23) aufweist, das mindestens zwei benachbarte Leitungsschichten durchdringt; und
die Vielzahl von gestapelten ersten elektronischen Komponenten ferner eine elektronische Komponente zweiter Größe umfasst, die elektronische Komponente zweiter Größe in dem dritte Durchgangsloch eingebettet ist und eine Dicke der elektronischen Komponente zweiter Größe größer als eine Dicke der elektronischen Komponente erster Größe ist.

4. Stromversorgungseinrichtung nach einem der Ansprüche 1 bis 3, ferner umfassend eine erste Verbindungsleitungsschicht (31) und eine zweite Verbindungsleitungsschicht (32), wobei
sich die erste Verbindungsleitungsschicht auf dem Substratrahmen befindet und sich die zweite Verbindungsleitungsschicht auf einer Seite befindet, die von dem Substratrahmen stammt und die der ersten Verbindungsleitungsschicht abgewandt ist; und
ein Ende einer Wicklung der Induktorkomponente elektrisch mit der ersten Verbindungsleitungsschicht verbunden ist, und das andere Ende der Wicklung der Induktorkomponente elektrisch mit der zweiten Verbindungsleitungsschicht verbunden ist.

5. Stromversorgungseinrichtung nach Anspruch 4, wobei in der Vielzahl von gestapelten ersten elektronischen Komponenten eine auf einer oberen Schicht gestapelte erste elektronische Komponente elektrisch mit der ersten Verbindungsleitungsschicht verbunden ist, eine auf einer unteren Schicht gestapelte erste elektronische Komponente elektrisch mit der zweiten Verbindungsleitungsschicht verbunden ist und eine auf einer mittleren Schicht gestapelte erste elektronische Komponente über eine vertikale Verbindungskomponente (4) elektrisch mit der ersten Verbindungsleitungsschicht oder der zweiten Verbindungsleitungsschicht verbunden ist.

6. Stromversorgungseinrichtung nach einem der vorhergehenden Ansprüche, wobei die mindestens eine zweite elektronische Komponente auf der eingebetteten Paketstruktur verpackt ist.

7. Stromversorgungseinrichtung nach einem der vorhergehenden Ansprüche, wobei die mindestens eine zweite elektronische Komponente in einer zweiten Leiterplatte (300) eingebettet ist und die zweite Leiterplatte elektrisch mit der eingebetteten Paketstruktur verbunden ist.

8. Stromversorgungseinrichtung nach einem der vorhergehenden Ansprüche, wobei die mindestens eine zweite elektronische Komponente ferner mindestens eine Kondensatorkomponente und/oder mindestens eine Widerstandskomponente umfasst.

9. Stromversorgungseinrichtung nach einem der vorhergehenden Ansprüche, ferner umfassend ein Wärmeableitungsmodul, wobei eine Oberfläche, die von dem Chip stammt und die der eingebetteten Paketstruktur abgewandt ist, mit dem Wärmeableitungsmodul verbunden ist.

10. Stromversorgungseinrichtung nach Anspruch 9, wobei das Wärmeableitungsmodul eine Metallschicht (400) ist, die eine Verpackungsoberfläche der mindestens einen zweiten elektronischen Komponente bedeckt; oder
das Wärmeableitungsmodul eine Metallschicht (400), welche die Oberfläche bedeckt, die von dem mindestens einen Chip stammt und die der eingebetteten Paketstruktur abgewandt ist, und einen Kühlkörper umfasst, der mit der Metallschicht verbunden ist.

11. Elektronische Vorrichtung, umfassend: eine dritte Leiterplatte und die Stromversorgungseinrichtung nach Anspruch 7, die auf der dritten Leiterplatte angeordnet ist.

## Revendications

1. Appareil d'alimentation électrique comprenant une structure de boîtier intégrée (100), comprenant : un cadre de substrat (1), un composant inducteur (L) intégré dans le cadre de substrat, et une pluralité de premiers composants électroniques empilés qui sont intégrés dans le cadre de substrat, dans lequel le composant inducteur et la pluralité de premiers composants électroniques empilés sont intégrés dans différentes positions du cadre de substrat ;
une épaisseur du composant inducteur est supérieure à une épaisseur de l'une quelconque de la pluralité de premiers composants électroniques ; et
l'une quelconque de la pluralité de premiers composants électroniques est un composant de condensateur (C) ou un composant de résistance (R) ;
**caractérisé en ce que** l'appareil d'alimentation électrique comprend également au moins un second composant électronique situé sur la structure de boîtier intégrée, dans lequel l'au moins un second composant électronique comprend au moins une puce (IC), dans lequel l'au moins un composant électronique est conditionné sur une première carte de circuit imprimé (200), et la première carte de circuit imprimé est connectée électriquement à la structure de boîtier intégrée.

2. Appareil d'alimentation électrique selon la revendication 1, dans lequel le cadre de substrat comporte une pluralité de couches de lignes empilées (11) ;
la pluralité de couches de lignes empilées comporte des premiers trous traversants (22) qui pénètrent dans toutes les couches de lignes, et le composant inducteur est intégré dans les premiers trous traversants ; et
la pluralité de couches de lignes empilées comporte également un deuxième trou traversant (22) qui pénètre dans une couche de lignes, la pluralité de premiers composants électroniques empilés comprend un composant électronique de première taille, et le composant électronique de première taille est intégré dans le deuxième trou traversant.

3. Appareil d'alimentation électrique selon la revendication 2, dans lequel la pluralité de couches de lignes empilées comporte également un troisième trou traversant (23) qui pénètre dans au moins deux couches de lignes adjacentes ; et
la pluralité de premiers composants électroniques empilés comprend également un composant électronique de seconde taille, le composant électronique de seconde taille est intégré dans le troisième trou traversant, et une épaisseur du composant électronique de seconde taille est supérieure à une épaisseur du composant électronique de première taille.

4. Appareil d'alimentation électrique selon l'une quelconque des revendications 1 à 3, comprenant également une première couche de ligne d'interconnexion (31) et une seconde couche de ligne d'interconnexion (32), dans lequel
la première couche de ligne d'interconnexion est située sur le cadre de substrat, et la seconde couche de ligne d'interconnexion est située sur un côté qui est celui du cadre de substrat et qui est éloigné de la première couche de ligne d'interconnexion ; et
une extrémité d'un enroulement du composant inducteur est connectée électriquement à la première couche de ligne d'interconnexion, et l'autre extrémité de l'enroulement du composant inducteur est connectée électriquement à la seconde couche de ligne d'interconnexion.

5. Appareil d'alimentation électrique selon la revendication 4, dans lequel dans la pluralité de premiers composants électroniques empilés, un premier composant électronique empilé sur une couche supérieure est connecté électriquement à la première couche de ligne d'interconnexion, un premier composant électronique empilé sur une couche inférieure est connecté électriquement à la seconde couche de ligne d'interconnexion, et un premier composant électronique empilé sur une couche intermédiaire est connecté électriquement à la première couche de ligne d'interconnexion ou à la seconde couche de ligne d'interconnexion par l'intermédiaire d'un composant d'interconnexion vertical (4).

6. Appareil d'alimentation électrique selon une quelconque revendication précédente, dans lequel l'au moins un second composant électronique est conditionné sur la structure de boîtier intégrée.

7. Appareil d'alimentation électrique selon une quelconque revendication précédente, dans lequel l'au moins un second composant électronique est intégré dans une deuxième carte de circuit imprimé (300), et la deuxième carte de circuit imprimé est connectée électriquement à la structure de boîtier intégrée.

8. Appareil d'alimentation électrique selon une quelconque revendication précédente, dans lequel l'au moins un second composant électronique comprend également au moins un composant de condensateur et/ou au moins un composant de résistance.

9. Appareil d'alimentation électrique selon une quelconque revendication précédente, comprenant également un module de dissipation de chaleur, dans lequel une surface qui est celle de l'au moins une puce et qui est éloignée de la structure de boîtier intégrée est connectée au module de dissipation de chaleur.

10. Appareil d'alimentation électrique selon la revendication 9, dans lequel le module de dissipation de chaleur est une couche métallique (400) recouvrant une surface de conditionnement de l'au moins un second composant électronique ; ou
le module de dissipation de chaleur comprend une couche métallique (400) recouvrant la surface qui est celle de l'au moins une puce et qui est éloignée de la structure de boîtier intégrée, et un dissipateur thermique connecté à la couche métallique.

11. Dispositif électronique, comprenant : une troisième carte de circuit imprimé et l'appareil d'alimentation électrique selon la revendication 7 qui est disposé sur la troisième carte de circuit imprimé.
